(19) Europäisches Patentamt
European Patent Office
Office européen des brevets

(11) **EP 1 803 950 A1**

(12) **EUROPEAN PATENT APPLICATION**
published in accordance with Art. 158(3) EPC

(43) Date of publication:
**04.07.2007 Bulletin 2007/27**

(51) Int Cl.:
*F16C 29/06* (2006.01)   *F16C 33/37* (2006.01)
*F16C 33/66* (2006.01)   *F16H 25/22* (2006.01)
*F16H 25/24* (2006.01)

(21) Application number: **05788317.5**

(22) Date of filing: **30.09.2005**

(86) International application number:
**PCT/JP2005/018200**

(87) International publication number:
**WO 2006/035947 (06.04.2006 Gazette 2006/14)**

(84) Designated Contracting States:
**DE FR**

(30) Priority: **30.09.2004 JP 2004288145**
**30.09.2005 JP 2005287738**

(71) Applicant: **THK CO., LTD.**
**Shinagawa-ku,**
**Tokyo 141-0031 (JP)**

(72) Inventors:
• **YAMANAKA, Shigeru,**
**c/o THK Co., Ltd**
**Tokyo 1410031 (JP)**

• **YANG, Hong,**
**c/o THK Co., Ltd**
**Tokyo 1410031 (JP)**

(74) Representative: **Jentschura, Rolf**
**Viering, Jentschura & Partner**
**Patent- und Rechtsanwälte**
**Postfach 22 14 43**
**80504 München (DE)**

(54) **ROLLING GUIDE DEVICE**

(57)     A rolling guide device 160 is provided with a track rail 161 as a track member and a movable member 163 mounted to the track rail 161 to be movable through balls 162. A solid lubricant film is formed to the ball 162 by using a closed magnetic field unbalanced magnetron spattering apparatus (CUMS apparatus). The solid lubricant film has a low friction coefficient at the outermost surface of the film, withstands an inner repeated stress, and has a high adhesion performance. Such solid lubricant film has never been from its inside or boundary portion and wears at the minimum speed from the film surface, so that a reliable and highly ideal solid lubricating function can be attained, and by applying the solid lubricant film having improved adhesion performance and abrasion resistance to the rolling guide device, there can be provided a rolling guide device usable in a specific environmental condition such as an undesirable lubricating environment, high temperature vacuum condition, or an oil-free condition.

FIG. 12

160

**Description**

Technical Field

The present invention relates to a rolling guide device, and more particularly, to a rolling guide device in which a solid lubricant film is formed by inducing metallic atom to a laminated crystal compound with respect to a surface of a rolling member, a loaded rolling passage or non-loaded rolling passage.

Background Art

For example, in a rolling slide member such as rolling bearing, in order to reduce rolling friction of a rolling member or sliding friction thereof and to thereby improve durability of the bearing, a liquid type lubricant such as grease is supplied. However, in a method of using a liquid type lubricant, steam occurring from such lubricant becomes a source of environmental contamination, thus providing a problem in a case where the rolling slide member is utilized under a highly sealed vacuum condition which requires a high cleanness such as in a semiconductor manufacturing facility.

Then, the durability and usable life of a rolling slide member used under such a specific environment have been improved by forming a diamond-like-carbon (called "DLC" hereinlater) film on a rolling surface of such member. This DLC film is formed by a known PVD (physical vapor deposition) or CVD (chemical vapor deposition), and the surface of the film has a hardness corresponding to the diamond (plastic deformation hardness more than 10GPa) and has a small sliding resistance having a friction coefficient of less than 0.2, to which an attention is hence paid as a new abrasion resistance film (for example, refer to following patent publications 1 to 5).

Patent Publication 1: Japanese Patent Unexamined Application Publication No. HEI 09-144764

Patent Publication 2: Japanese Patent Unexamined Application Publication No. 2000-136828

Patent Publication 3: Japanese Patent Unexamined Application Publication No. 2000-205277

Patent Publication 4: Japanese Patent Unexamined Application Publication No. 2000-205279

Patent Publication 5: Japanese Patent Unexamined Application Publication No. 2000-205280

Patent Publication 6: British Patent Specification No. 2,303,380

Disclosure of The Invention

However, the DLC film formed by the PVD method or CVD method is insufficient in adhesion performance or abrasion resistance of the film, and a further improvement has been required. More specifically, the DLC film has a strength extremely lower in comparison with its hardness, so that the film has been effectively utilized for a portion to which a sliding motion is mainly performed, but to the rolling motion, as the film is destroyed and peeled off from the inside thereof, such film is hardly used for the rolling member, and its use has been limited to the use under an extremely low surface pressure of less than 700MPa. In addition, the DLC film formed by the PVD method is deteriorated in its abrasion resistance in the vacuum condition.

Furthermore, the rolling guide devices are used under a specific environment such as undesirable lubrication environment including poor lubrication environment, a high temperature vacuum condition, or a condition in which any lubricant such as grease is not used. Therefore, it has been requested to improve adhesion performance and abrasion resistance and to adapt a solid lubrication film realizing improvement of the durability and long life time.

Especially, in a linear guide device or a rolling guide device such as ball spline device or ball screw device, when a plurality of balls disposed in an endless circulation passage is moved from a loaded rolling passage to a non-loaded rolling passage, since a dynamical non-continuous portion or a colliding portion exists, it is essential to apply a solid lubrication film capable of withstanding a surface pressure generated at such portions or a rolling sliding motion.

The present invention was conceived in consideration of the above circumstances and an object thereof is to provide a rolling guide device having improved abrasion resistance and fatigue strength due to the rolling motion by applying a solid lubricant film having improved adhesion performance and abrasion resistance to a rolling guide device such as linear guide device, a ball spline device or ball screw device in comparison with a DLC film formed by a PVD method or a CVD method in a prior art.

Another object of the present invention is to provide a rolling guide device having a sufficient surface pressure and being capable of withstanding the rolling sliding motion under a specific environment such as undesirable lubrication environment, a high temperature vacuum condition or an oil-free condition.

Means for solving The Problem

The rolling guide device according to the present invention includes:

a track member; and

a movable member mounted to the track member to be movable through a number of rolling members,

the number of rolling members being disposed in an endless circulation passage composed of a loaded rolling passage formed between the track member and the movable member and a non-loaded rolling passage formed by connecting one and other ends of the loaded rolling passage,

wherein a solid lubricant film is formed by inducing a metallic atom into a laminated crystal compound with respect to at least one surface of the number of rolling members, the loaded rolling passage and the non-loaded rolling passage.

In the rolling guide device of the present invention, it is preferred that the solid lubricant film is formed by a closed magnetic field unbalanced magnetron spattering method.

Further, in the rolling guide device of the present invention, it is preferred that the laminated crystal compound includes at least one of $MoS_2$, $WS_2$ or graphite, and the metallic atom includes at least one of titanium, tungsten, aluminum, chromium, zirconium, silica or boron.

Furthermore, in the rolling guide device of the present invention, it is preferred that the solid lubricant film has a film thickness of 0.5 to 3 $\mu$m.

Still furthermore, in the rolling guide device of the present invention, it is preferred that the metallic atom has a content of less than 20% with respect to the solid lubricant film.

Still furthermore, in the rolling guide device of the present invention, it is desirable that a critical adhesion performance of the solid lubricant film is not less than 40N in a scratch test using Rockwell diamond indenter.

Still furthermore, in the rolling guide device of the present invention, it is desirable that the solid lubricant film has a Vickers hardness (Hv) of not less than 500 and has a friction coefficient of not more than 0.07 with respect to a steel material having a hardness of not less than HRC55 in a vacuum condition of not more than $1 \times 10^{-3}$ Torr.

Still furthermore, in the rolling guide device of the present invention, it is preferred that a spacer member having a hardness softer than that of the solid lubricant film and the rolling member is disposed between the rolling members, the spacer member being a spacer ball having a diameter less than that of the rolling member or a retainer.

It is further noted that the above preferred embodiments do not include all the necessary features of the present invention and the present invention includes sob-combinations of the above features.

Effects of The Invention

According to the present invention, it is possible to provide a rolling guide device having improved abrasion resistance and fatigue strength due to the rolling motion by applying a solid lubricant film having improved adhesion performance and abrasion resistance to a rolling guide device such as linear guide device, ball spline device or ball screw device in comparison with a DLC film formed by a PVD (physical vapour deposition) method or a CVD (chemical vapour deposition) method in a prior art. In addition, it is also possible to provide a rolling guide device having a sufficient surface pressure and being capable of withstanding the rolling sliding motion under a specific environment such as undesirable lubricating environment, a high temperature vacuum condition or an oil-free condition.

Brief Description of The Drawing

Fig. 1 is a schematic view showing an upper surface of a general CUMS apparatus utilized for an embodiment of the present invention.

Fig. 2 is a schematic view showing a side surface of the general CUMS apparatus utilized for the embodiment of the present invention.

Fig. 3 is a view explaining a CUMS apparatus of TEER Coatings Co. Ltd. utilized for manufacturing a solid lubricant film according to the embodiment of the present invention.

Fig. 4 is a view representing a film structure of a solid lubricant film according to the present embodiment in a case of being formed as a multi-layered film.

Fig. 5 is a view representing a solid lubricant film according to the present embodiment formed as a mixture film (amorphous film).

Fig. 6 shows a view of a loaded cycle applied to an LM guide in a non-lubricant durability test.

Fig. 7 is a side view of an outer appearance showing a schematic structure of a non-lubricant durability test machine utilized for a non-lubricant durability test.

Fig. 8A is an outer perspective sectional view for explaining a schematic structure of an LM guide mounted to a non-lubricant durability test machine.

Fig. 8B is a longitudinal sectional view explaining a structure of an endless circulation passage formed to the LM guide of Fig. 8A.

Fig. 9 is a bar graph showing a test result of the non-lubricant durability test.

Fig. 10 is a top plan view of an outer appearance showing a schematic structure of a dust generation test machine utilized in a dust generation test.

Fig. 11 is a bar graph showing a test result of the dust generation test.

Fig. 12 is a sectional view of a linear type rolling guide device to which the solid lubricant film according to the present invention is utilized, in a direction perpendicular to a track rail thereof.

Fig. 13 is a plan view of a linear type rolling guide device to which the solid lubricant film according to the present embodiment is utilized.

Fig. 14 shows a specific shape of a spacer member used for the linear type rolling guide device shown in Figs. 12 and 13.

Fig. 15 is a modified embodiment of the linear type rolling guide device shown in Fig. 12.

Fig. 16 is a modified embodiment of the linear type rolling guide device shown in Fig. 13.

Fig. 17 is a view showing a linear type rolling guide device, having a four rows of threads forming endless circulation passages, to which the solid lubricant film according to the present embodiment is applicable.

Fig. 18 is a view showing one example of various modifications of a spacer member shown in Fig. 18.

Fig. 19 is a view showing a different inserting state of the spacer member different from that of Fig. 18.

Fig. 20 is a view showing a further different example of the spacer member according to the present embodiment.

Fig. 21 is a view showing a modified example of the spacer member shown in Fig. 20.

Fig. 22 is a view showing one example of a ball screw device to which the solid lubricant film according to the present embodiment is utilized.

Fig. 23 is a view showing another example of a ball screw device to which the solid lubricant film according to the present embodiment is utilized.

Fig. 24 is a view showing a further example of a ball screw device to which the solid lubricant film according to the present embodiment is utilized.

Reference Numerals

10a, 10b, 10c, 10e --- magnetron, 11 --- outer ring magnet, 12inner core magnet, 13 --- object to be treated, 14 --- carrier, 15 --- motor, 16a, 16b, 16c, 16d --- target, 20 --- inactive gas control loop, 21 --- high speed electro-magnetic valve, 22 --- light emitting monitor, 23photo-electron amplifier, 40 --- multi-layer film, 42 --- boundary adhesion layer, 50 --- mixture film (amorphous film), B --- magnetic line, Cworking space, $\alpha$ --- layer including $MoS_2$ more than titanium (Ti) in ratio, $\beta$ --- layer including $MoS_2$ less than Titanium (Ti) opposite to $\alpha$, 60 --- non lubricant durability test machine, 61 --- base, 62 --- derrick, 63spring, 64 --- load cell, 65 --- motor, 70 --- LM guide, 71 --- track rail, 71a --- ball rolling groove, 72 --- movable block, 72a --- loaded ball rolling groove, 73 --- ball, 74 --- endless circulation passage, 75 --- spacer ball, 80 --- dust generation test machine, 81 --- motor, 82 --- motion guide device, 82a --- ball screw, 82b --- movable block, 83 --- structural member, 85 --- acrylic case, 86 --- particle counter, 160 --- rolling guide device, 161 --- track rail, 161a, 164a --- loaded rolling groove, 161bbolt fastening hole, 162 --- ball, 163 --- movable member, 164 --- block body, 164b --- upper surface of block body, 164c --- female screw, 165 --- mold product, 165a --- ball guide portion, 165b --- ball support portion, 166 --- side lid, 166a --- ball guide groove, 167 --- loaded rolling passage, 168 --- return passage, 169 --- direction changing passage, 170non-loaded rolling passage, 171 --- endless circulation passage, 172guide groove, 180, 202 --- spacer, 181 --- seat, 182 --- arm, 185spacer ball, 186 --- retainer, 187 --- spacer, 188 --- belt-like member, 190 --- ball screw device, 191 --- screw shaft, 191a, 193a --- loaded rolling groove, 192 --- nut, 192a --- flange, 193 --- nut body, 194 --- lid member, 195 --- loaded rolling passage, 196 --- return passage, 197return piece, 198 --- cover, 199 --- direction changing passage, 200non-loaded rolling passage, 201 --- endless circulation passage, 210return pipe, 220 --- deflector

Best Mode for embodying The Invention

Hereunder, preferred embodiments for embodying the present invention will be described with reference to the accompanying drawings. Further, it is to be noted that the following embodiments do not limit the inventions recited in the respective claims, and all the combinations of characteristic features described in the embodiments is not always essential for the solution of the present invention.

Furthermore, in the present embodiments, there are explained examples in which a thin film as a solid lubricant film is formed to a surface of a ball as a rolling member utilized for a rolling guide device by using a Closed magnetic Unbalanced Magnetron Spattering device (called CUMS device hereinlater) manufactured by a TEER Coatings Ltd. The reason why this device is utilized resides in that a plasma having high density can be obtained in comparison with a usual Unbalanced Magnetron Spattering method (DBMS, Trademark, method), and an ion current density five times higher than that of usual one can be obtained, so that a solid lubricant film applicable to a rolling guide device can be obtained.

Further, the "rolling guide device" in this embodiment is not limited to one provided with balls, but includes a general rolling bearing utilized for a machine tool, a non-lubricant bearing utilized in vacuum condition, linear guide, linear guide device, ball spline device, ball screw device and the like including device performing rolling/sliding motion.

[Structure of CUMS Device]

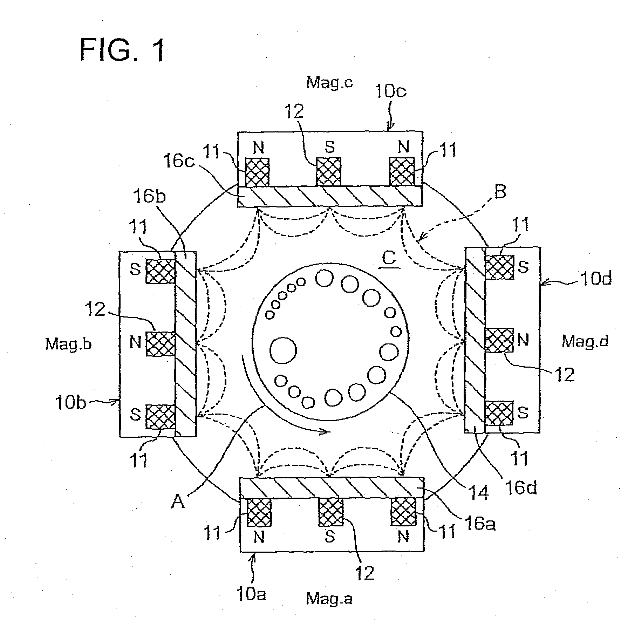

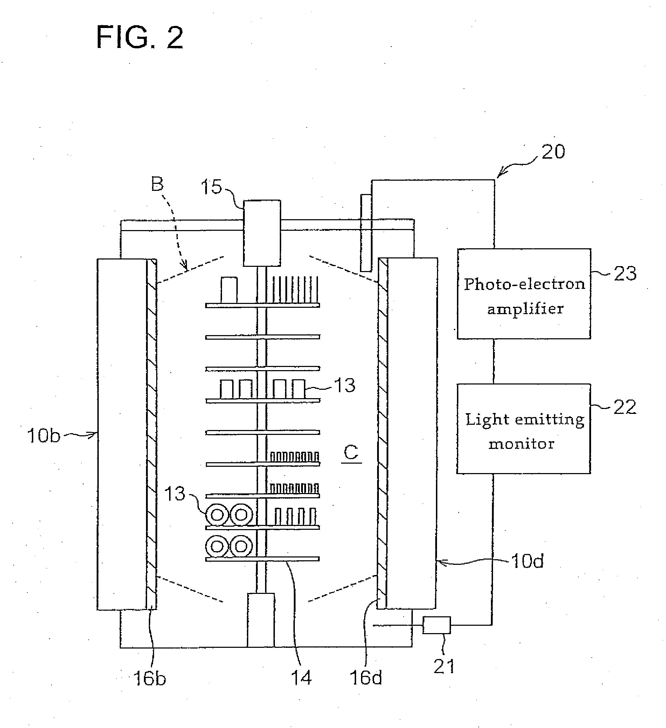

First, a CUMS device utilized for forming a solid lubricant film applicable to a rolling guide device according to the present invention will be described with reference to the accompanying drawings. Fig. 1 is a schematic view showing an upper surface of a general CUMS apparatus used in the present embodiment. Fig. 2 is a schematic view showing a side surface of the general CUMS apparatus used in the present embodiment.

The CUMS apparatus shown in Figs. 1 and 2 includes four magnetrons 10a, 10b, 10c and 10d, each of which is provided with an outer ring magnet 11 and a central inner core magnet 12. The four magnetrons 10a, 10b, 10c and 10d are arranged around carriers 14 utilized as means for arranging an object to be treated 13 to which a film is formed in a suitable position. The carrier 14 is constructed to be rotatable around one axis in an arrowed direction A by a driving mechanism such as motor 15.

In the CUMS apparatus shown in Figs. 1 and 2, the magnetrons 10b and 10d and the outer ring magnet 11 show S-poles, and the inner core magnet shows an N-pole. On the other hand, the magnetrons 10a and 10c and the outer ring magnet 11 show N-poles and the inner core magnet shows an S-pole. According to such arrangement, magnetic lines B of the four magnetrons 10a, 10b, 10c and 10d forms a continuous barrier, and hence, electrons dispersed from the magnetron plasma can be captured. That is, since the magnetic lines B limit a working space C so as to surround the carriers 14, a film can be formed to the object to be treated 13 in the electromagnetically closed state. Thus, according to the CUMS apparatus shown in Figs. 1 and 2, it becomes possible to generate high density plasma at a low voltage, and realize the formation of a thin film with high quality which is impossible by a usual Unbalanced Magnetron Spattering (UBMS, Registered Trademark) apparatus. Further, the working space C defined by the magnetic lines B can be optionally set in its range and is not limited to upper and lower (vertical) ends in the axial direction of the carrier 14.

The four magnetrons 10a, 10b, 10c and 10d are provided with targets 16a, 16b, 16c and 16d, respectively, as a supply material for spattering operation. These targets 16a, 16b, 16c and 16d are arranged so as to cover pole surfaces of the magnets facing to the carriers 14. The respective magnetrons 10a, 10b, 10c and 10d have back plates made of soft iron, not shown, thus forming an inner magnetic circuit for each of the magnetrons 10a, 10b, 10c and 10d.

As can be understood from the above description, according to the CUMS apparatus of the present embodiment, the objects to be treated 13, which are oppositely disposed so that the material spattered from the targets 16a, 16b, 16c and 16d adhere, can be enclosed in the unbalanced magnetic field generated by the magnets 11 and 12 arranged as unbalanced magnetic field generating means. Accordingly, the CUMS apparatus permits to realize the formation of the film to the object to be treated 13 in the electromagnetically closed working space C. This structure is based on the fact that it becomes possible to generate high density plasma at low voltage by intentionally generating the unbalanced magnetic field on the surfaces of the targets 16a, 16b, 16c and 16d in the space closed electromagnetically, and hence, to form a thin film having high quality on the object to be treated 13.

Further, when the CUMS apparatus is used, an inert gas such as argon gas is supplied in a chamber of the apparatus. The supply of the inert gas is performed by means of an inert gas control loop 20 such as shown in Fig. 2. The inert gas control loop 20 is provided with a high-speed electromagnetic valve 21, a light-emitting monitor 22 and a photomultiplier tube 23 so as to maintain a fine working environment through continuous monitoring of the inert gas in the chamber of the apparatus. In such chamber, a voltage having a potential difference is applied to the magnetrons 10a, 10b, 10c and 10d, and electrons are accelerated by such potential difference so as to ionize gas and then to generate increased number of electrons and argon gas. The argon ion existing in the chamber bombards the targets 16a, 16b, 16c and 16d of the supply material and the solid lubricant film of the supply material can thus be manufactured.

[Film Forming Method of Solid Lubricant Film]

A. Setting Condition of CUMS Apparatus

Next, a specific method of manufacturing the solid lubricant film applicable to the rolling guide device according to the present embodiment by utilizing the CUMS apparatus mentioned above will be explained. As the CUMS apparatus performing the spattering, there is used a CUMS apparatus (Patent Publication 6: specification of British Patent No. 2,303,380 given to the TEER Coating Ltd.) By adopting film forming means in a closed magnetic field unbalanced magnetron spattering method using such apparatus, the spattering of high ion current at low voltage is enabled, so that it becomes possible to form an homogeneity and high density film at relatively short time period.

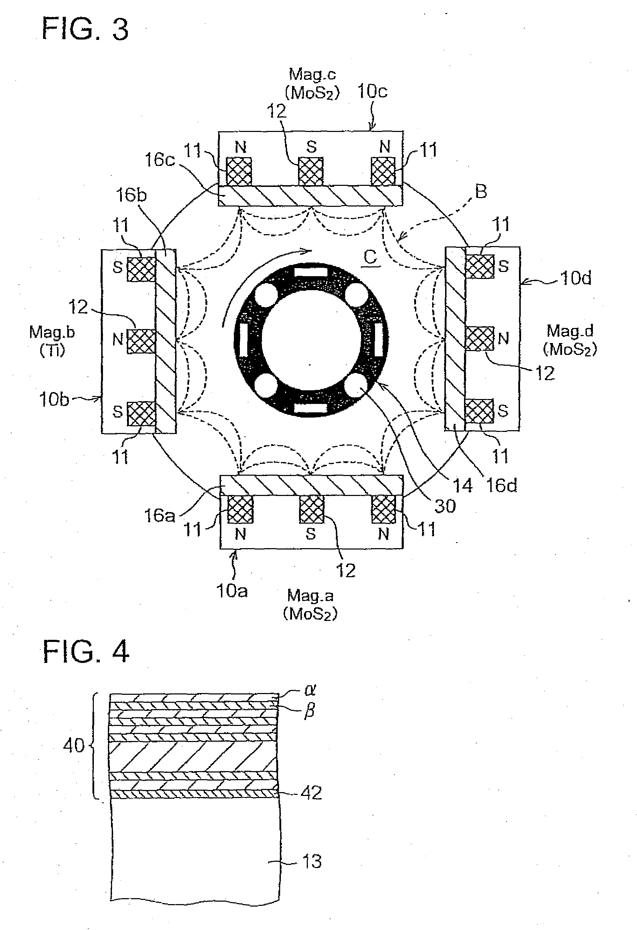

The carrier 14 shown in Fig. 3 is provided with a jig 30 for fixing the object 13, and this jig 30 carries out self-rotation and revolution motions as well as simple rotating motion. Accordingly, the solid lubricant film can be formed to the object to be treated 13 with uniform film thickness and quality important as a rolling member.

Herein, one characteristic point for the CUMS apparatus utilized in this embodiment is an adoption of titanium (Ti) for one of the target 16b of the targets 16a, 16b, 16c and 16d arranged so as to surround the carrier 14. $MoS_2$ is also arranged for the other targets 16a, 16c and 16d. This structure is based on the fact that, by constituting at least one of the plurality of targets 16a, 16b, 16c and 16d to be spattered with a metallic atom such as titanium (Ti) as an active metal and constituting the other targets with a layer crystal compound such as $MoS_2$, the metallic atom is induced into the laminated crystal compound and interlayer strength is improved. Further, in the present embodiment, since there is adopted the film forming method of the closed magnetic field unbalanced magnetron spattering method capable of forming the film having homogeneity and high density at relatively short time period, an obtained solid lubricant film has a low friction coefficient at a most outer surface of the film, can withstand inner repeated stress, and provides high adhesion performance. Such solid lubricant film is not destroyed from its inner side or boundary portion, so that when applied to the rolling guide device, wearing starts from the film surface at the minimum speed, thus realizing a highly reliable and ideal condition of the film.

As the metallic atom induced into the layer crystal compound, is adopted, other than the titanium (Ti), tungsten (W), aluminium (Al), chromium (Cr), zirconium (Zr), silica (Si) or boron (B), and so on. These metallic atoms may be used solely or in combination.

In addition, in the present embodiment, although the $MoS_2$ is utilized as the targets 16a, 16b, 16c and 16d, this is based on the fact that the $MoS_2$ is a well known solid lubricant. However, the target material is not limited to the $MoS_2$, and other target materials may be utilized. For example, it is preferred to use a compound of which crystal has a laminated (layer) structure such as $WS_2$ or graphite.

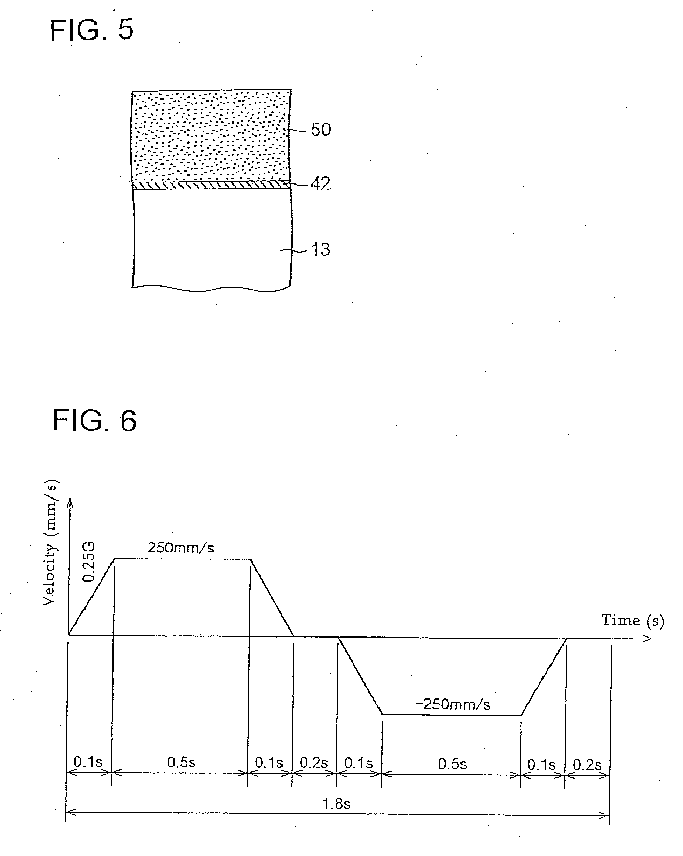

Further, in the CUMS apparatus according to the present embodiment, it may be possible to additionally arrange targets other than those mentioned above. That is, there is no limit in number of the targets, and a third material may be arranged to one target so as to add it to a boundary adhering layer 42 or multi-layer film 40 as shown in Fig. 4, or a mixture film 50 shown in Fig. 5 to thereby improve the adhesive performance, lubricating property and film strength as the solid lubricant. Further, in order to improve the adhesive performance, it may be preferred to use, as the target material, tungsten (W), aluminium (Al), chromium (Cr), zirconium (Zr), silica (Si) or boron (B) other than the titanium (Ti).

B. Operating Sequence of CUMS Apparatus

Hereunder, operating sequence of the CUMS apparatus will be described. First, vacuuming condition in the chamber of the apparatus for carrying out the spattering operation is made to $5\text{-}6 \times 10^{-6}$ Torr. Thereafter, the surface of the object to be treated 13 as a film is cleaned. In addition, water content and harmful gas such as hydrogen sulfide in the apparatus chamber is removed. An argon gas is then introduced and the vacuuming condition in the apparatus chamber is made to $1 \times 10^{-3}$ Torr. Under the condition, pulse voltage of -350V is applied onto the carrier 14 for 15 minutes to spatter only the titanium (Ti) to thereby form metal Ti layer (boundary adhesion layer 42), having a thickness of 0.1 to 0.3$\mu$m on a base material. According to this operation, the embrittlement of the solid lubricant film can be itself prevented, and a fine film which achieves function as solid lubricant can be formed.

Consequently, the film formation is continued by the spattering method by increasing the pulse voltage to -30V with respect to the carrier 14. At this time, each target has a range of 0.2-1.0A, but the spattering amount of $MoS_2$ is increased as time passes and the content of the titanium (Ti) is finally regulated to less than 20% with respect to the whole film. At this time, the vacuum degree is controlled to about 5mTorr.

These conditions may be changed in accordance with the characteristics of the film or productivity thereof. Although the film thickness can be controlled to be in a range of 0.1 to 10$\mu$m, in order to be applied to the rolling guide device of the present invention, it is desirable that the film thickness is made to be within 0.5 to 3 $\mu$m. This is based on the fact that when the film thickness of the solid lubricant film exceeds 3 $\mu$m, rolling life time of the device is shortened by the increasing of the stress inside the film, and in the case of the film thickness of less than 0.5 $\mu$m, strength of the solid lubricant film itself can not be obtained. Further, in the described embodiment, the spattering operation was performed for 70 minutes under the conditions described above for forming the film having a uniform film thickness of about 1 $\mu$m. Further, in order to obtain a thick film, the spattering time may be elongated.

Although the rotating speed of the jig 30 attached to the carrier 14 may be freely set to the layer-to-layer (interlayer) distance between the multi-layer film 40 or to form the mixture film 50, the rotating speed is desirable to be set to 3-10 rotation/min, and is set to 5 rotation/min in this embodiment.

[Structure of Formed Solid Lubricant Film]

Structure of the solid lubricant film formed by the above mentioned processes will be described hereunder.

In the present embodiment, the structure of the solid lubricant film of the multi-layer film 40 and the mixture (amorphous) film 50 formed by using the four targets 16a, 16b, 16c and 16d in a number of selectable targets will be explained. The multi-layer film 40 has a two-layered structure having the titanium single layer and a mixture layer of titanium and MoS$_2$. On the other hand, the mixture film 50 is a film formed by simultaneously spattering the titanium (Ti) and MoS$_2$ into the amorphous state having no more clear crystal structure. Both the multi-layer film 40 and mixture film 50 have, as boundary adhesion layer 42, the titanium as active metal. Further, Fig. 4 is a view showing the film structure of the solid lubricant film according to the present embodiment formed to the multi-layer film 40, and Fig. 5 is a view showing the film structure of the solid lubricant film according to the present embodiment formed to the mixture film 50.

As the structure of the film to be formed, there is obtainable the multi-layer film 40 (Fig. 4) in which the multi-layers 40 includes layer structure of α/β/α/β/α/β - α/β/α/β/α/β, in which the a layer includes MoS$_2$ more than titanium (Ti) in ratio and the β layer includes Ti layer more than MoS$_2$ in ratio, and there is also obtainable the mixture film 50 (Fig. 5) in form of amorphous in which the layer structure is no more clear and has no clear crystal structure. These layer structures can be obtained by regulating the rotation number of the carrier 14, the energy to be applied to the respective targets, the voltage to the carrier 14, the shutter of the target and so on.

Further, with respect to the α and β layers explained herein, it may be possible to adopt a ratio of various elements or to set variations. Since the components of the material can be adjusted, it may be possible to optionally change the concentration of the respective elements and to form a gradient layer or gradient film.

[Characteristics of Formed Solid Lubricant Film]

Characteristics of the thus formed solid lubricant film were investigated. In this investigation, there were prepared plate-shaped test pieces made of SKH51(high speed tool steel) at surface roughness of less than Ra0.03, and a solid lubricant film was formed with the same conditions as those of the film forming method mentioned above. First, a ball-on-disc durability test was performed with respect to the test pieces. Friction rolling circle diameter was 8 mm, diameter of test ball was 5 mm, material was made of WC-6%Co, and line velocity at test friction generating portion was 200 mm/sec. In a test result, measured values of specific abrasive ratio in three stage levels of test loads of 1kg, 3.8kg and 7.6kg were all less than 7 x 10$^{-17}$m$^3$/Nm, and friction coefficient with respect to steel material having hardness of more than HRC 55 in vacuum condition was less than 0.07. Particularly, the test result in which in the level of load of 7.6kg, the specific abrasive ratio of less than 7 x 10$^{-17}$m$^3$/Nm was obtained shows the fact that the solid lubricant film formed according to the present embodiment was extremely excellent in performance.

In addition, in a scratch test using Rockwell diamond indenter with respect to the above mentioned test pieces, it was confirmed that the solid lubricant film of the present embodiment had the critical adhesion force of more then 40. Furthermore, it was also confirmed that the Vickers hardness (Hv) of the solid lubricant film of the present embodiment was more than 500.

[Evaluation by Non-lubricant Durability Test]

Next, evaluation based on the non-lubricant durability test was made in order to compare, in durability performance, the solid lubricant film according to the described embodiment with a DLC film of prior art. This non-lubricant durability test was performed under the conditions shown in the following Table 1 and by using an oil-free low-load durability test machine installed in an experiment chamber in an environment of room temperature, and an LM guide was set to this test machine. As the LM guide, there was prepared two types of LM guides, one of which has a structure on which a solid lubricant film according to the present embodiment was formed and the other one of which has a structure on which a conventional DLC film was formed, and movable blocks are repeatedly reciprocally moved with respect to tracks rails to compare durability performances of both types. Further, the reciprocal motion tests carried out by the LM guides were performed in accordance with the motion pattern of a load cycle shown in Fig. 6, and more specifically, the investigation was performed under two conditions of stroke: 150mm; velocity in linear motion: 250mm/s; acceleration velocity when turning back: 0.25G; dwell time: 0.2s; always applied load: 0.03C (162N); and 0.06C (324N).

Table 1 Non-lubricant Durability Test Condition

| Items | Contents |
| --- | --- |
| Stroke | 150 mm |
| Load | 0.03C, 0.06C |
| Velocity | ± 250mm/s |
| Accelerated Speed | 0.25G |

(continued)

| Items | Contents |
|---|---|
| Dwell Time | 0.2s |
| Lubrication | Oil Free |
| Test Machine | Oil-free Low-load Durability Test Machine |
| Test Environment | Room Temperature |

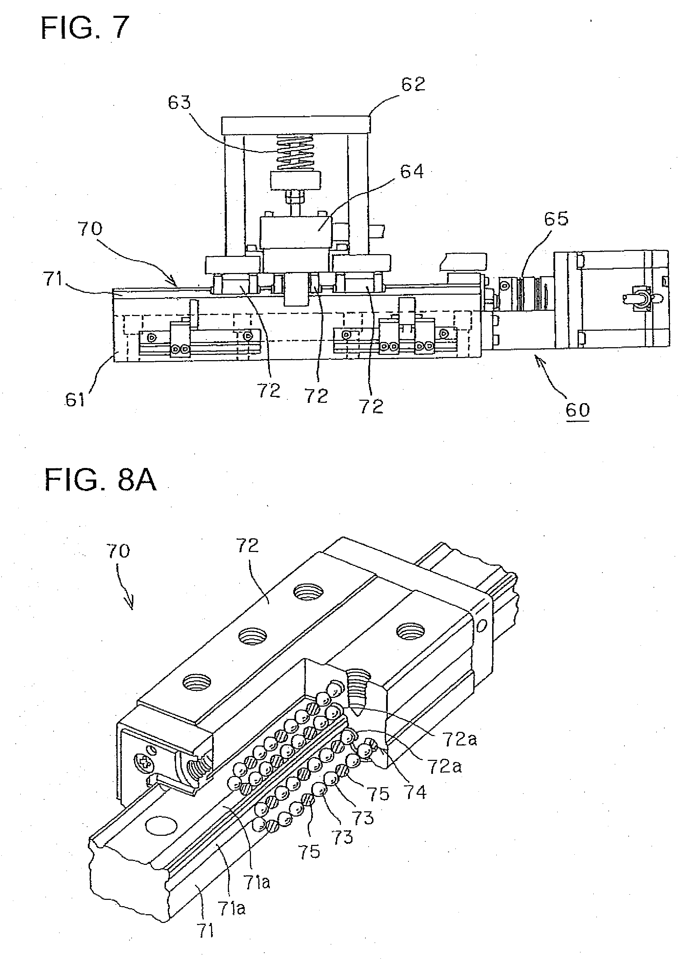

The used non-lubricant durability test machine 60 has a structure shown in Fig. 7. The LM guide 70 used for the test is provided with the track rail 71 which fixedly mounted on a base 61 of the non-lubricant durability test machine 60. On the track rail 71, three movable blocks 72 are mounted to be reciprocally movable, and a gate-shaped derrick 62 is assembled with two movable blocks 72 positioned both end sides. A spring 63 is attached to the derrick 62 so as to apply a perpendicularly downward load, this spring 63 is connected to the movable blocks 72 positioned on the center through a load cell 64. The load cell 64 measures the load of the spring 63 as a change in voltage, and hence, the application of stable load can be realized through load display, record and control. In addition, a ball screw is disposed beside the LM guide 70 so as to guide the motion of the LM guide in the direction parallel with the track rail 71 though the ball screw is hidden by the base 61 in Fig. 7. The rotating motion of this ball screw is controlled by a motor 65, and the ball screw is connected to the derrick 62 so as to reciprocally move the gate-shaped derrick 62 in the direction of the screw shaft. Therefore, in accordance with the rotating motion of the ball screw, the gate-shaped derrick 62 is moved, and thus, the controlled reciprocal movement of the movable blocks 72 can be performed.

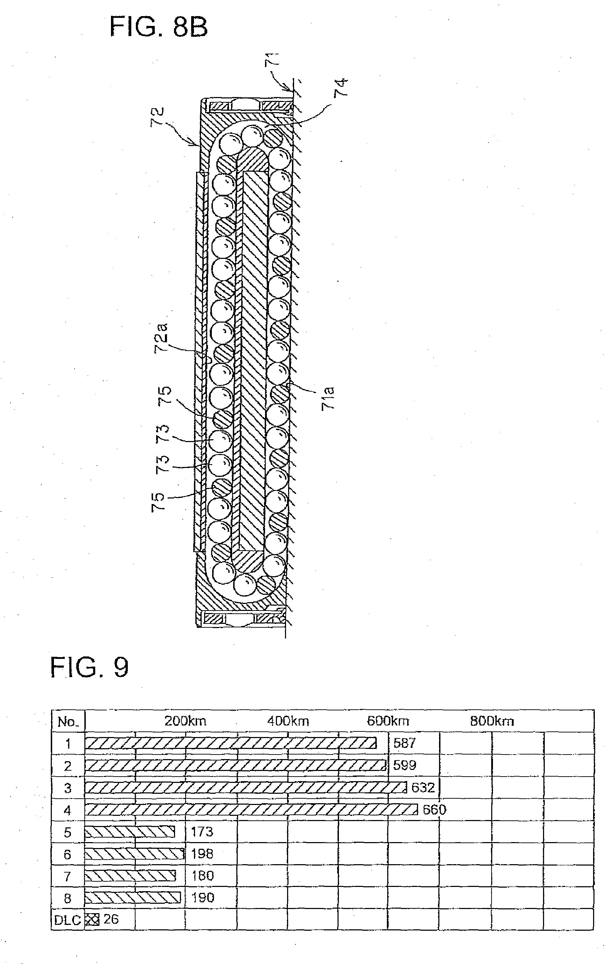

Furthermore, the LM guide 70 mounted on the non-lubricant durability test machine 60 has a structure shown in Figs. 8A and 8B. That is, the LM guide 70 is provided with the track rail 71 formed with a ball rolling groove 71a formed toward the longitudinal direction and the movable block 72 formed with a loaded ball rolling groove 72a corresponding to the ball rolling rove 71a and mounted to the track rail 71 through a number of balls 73. Therefore, the ball rolling groove 71a and the loaded ball rolling groove 72a constitutes an endless circulation passage 74, and a number of balls 73 are accommodated and arranged to be endlessly circulated in the endless circulation passage 74. According to such structure, the track rail 71 and the movable block 72 constituting the LM guide 70 can be relatively movable through the rolling of the balls 73.

Then, the solid lubricant film according to the present invention as an object to be tested was formed on the surface of a number of balls 73. In the LM guide 70 utilized for the present non-lubricant durability test, each of spacer balls 75 is formed of polytetrafluoroethylene resin (PTFE) and is arranged every three balls 73.

On the other hand, it is quite difficult in the recent technology to form the DLC film as the object to be compared so as to apply a high adhesion performance to the ball surface capable of withstanding the rolling motion under a high surface pressure, so that the DLC film was formed to the ball rolling groove 71a and the loaded ball rolling groove 72a to which the load from the ball is applied. The arrangement of the balls 73 and the spacer balls 75 were done under the same conditions as those mentioned with respect to the solid lubricant film of the present invention.

The results of the non-lubricant durability test performed under the conditions and by the method mentioned above, are shown in Table 2. For the solid lubricant film according to the present embodiment, eight samples No. 1 to No. 8 were prepared with the same film forming conditions, and the solid lubricant film was formed by introducing titanium (Ti) into $MoS_2$ by the apparatus and the method mentioned hereinbefore. Further, evaluation of the non-lubricant durability test was made under judgment such that a durable life time was deemed to be ended at a time when abrasion powder was generated even a little and by measuring a travelable (traveled) distance of the movable block 72 to be moved on the track rail 71 till that time.

Table 2: Non-lubricant Durability Test Result

| Test Sample | | Applied Load | Travelable Distance | Abnormal Abrasion |
|---|---|---|---|---|
| Solid Lubricant Film (Present Invention) | No. 1 | 0.03C | 587km | NO |
| | No. 2 | 0.03C | 599km | NO |
| | No. 3 | 0.03C | 632km | NO |
| | No. 4 | 0.03C | 660km | NO |
| | No. 5 | 0.06C | 173km | NO |
| | No. 6 | 0.06C | 198km | NO |
| | No. 7 | 0.06C | 180km | NO |
| | No. 8 | 0.06C | 190km | NO |
| Conventional DLC Film | | 0.03C | 26km | Early Broken |

As can be seen from the above Table 2, with the solid lubricant film according to the present invention, the travelable distance was 587km, even in the shortest distance, at the applied load of 0.03C(162N), which is extremely larger than the distance of 26km in the case of the conventional DLC film evaluated at the same applied load. Furthermore, in the case of the applied load of 0.06C (324N) (twice of former case), with the solid lubricant film of the present embodiment, the travelable distance was recorded as 173-198km and obtained an exceeded result of 6.6-7.6 times of the former DLC film case (half load). Fig. 9 is a bar graph representing the test result shown in the Table 2. The superiority of the solid lubricant film according to the present embodiment can be clearly recognized by visualizing the result of the non-lubricant durability test.

In an analysis of reason having obtained such good test result, it is considered that the solid lubricant film utilized in the present test had a Vickers hardness (Hv) of the film itself is about 750, which is almost equal to that of an object material (quench-and-temper steel of Hv800), did not attack the object material, which was slowly worn too. Further, since the hardness of the DLC film is of about Hv1500-4000 at room temperature and has a high rolling abrasion ratio to steel material (object material), it is predicted that the early breaking was generated.

In repeat, on this time non-lubricant durability test, in order to carry out the test and evaluate the test result under the possibly same conditions, the inventors of this application investigated whether there exists technology for forming the DLC film with the adhesiveness being applied to the ball surface. However, no technology exists at the present stage for stably forming the DLC film to the ball, and it was found that it was impossible to stably form the film to the ball as like as the solid lubricant film as in the present embodiment. From this fact, It will be found that the formation of the solid lubricant film according to the present embodiment is an epoch-making technology. The solid lubricant film of the present embodiment is an epoch-making technology capable of enhancing fatigue strength due to abrasion resistance and rolling motion in the rolling guide device, and only by the realization of the present invention, a rolling guide device having a sufficient surface pressure and withstanding the rolling sliding motion can be provided under a specific condition of bad lubricating environment, high temperature/high vacuum condition, or oil free condition, for example.

[Evaluation in Dust Generation Test]

Furthermore, the inventors also carried out a dust generation test so as to investigate performance and characteristics of the solid lubricant film of the present embodiment with respect to the generation of dust. In the dust generation test, an LM guide in which the solid lubricant film of the present embodiment was formed on the ball and an LM guide which has the same shape as that of the aforementioned LM guide and in which the solid lubricant film was not used but a vacuum grease was used, were compared.

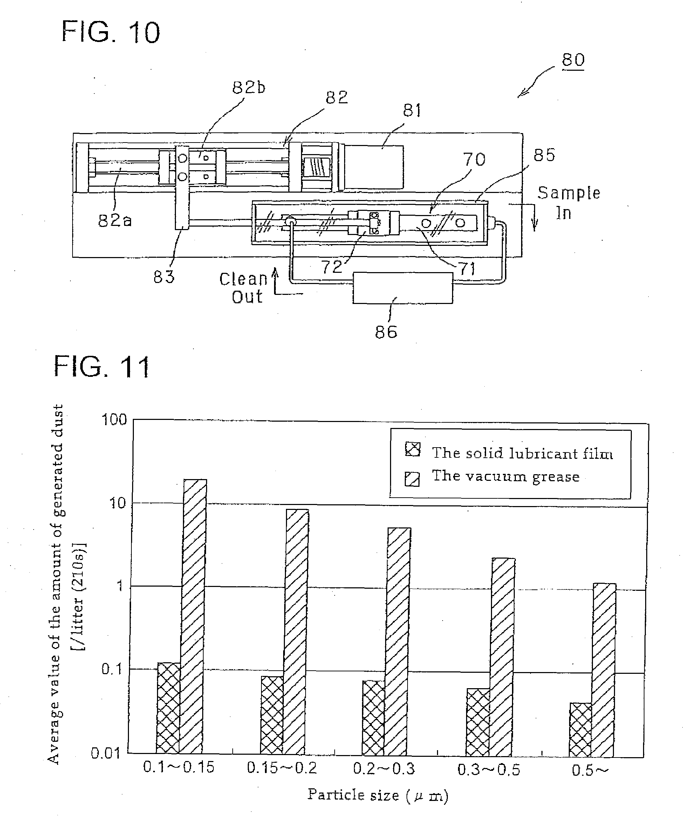

Furthermore, this dust generation test was carried out by using a dust generation test apparatus 80 shown in Fig. 10. This dust generation test apparatus 80 is mounted with the LM guide 80 explained with reference to Figs. 8A and 8B, and a motion guide device 82 is installed so as to be parallel with the LM guide 70. The motion guide device 82 is provided with a ball screw 82a connected to a motor 81 and a movable block 82b to be reciprocally movable in accordance with the rotating motion of the ball screw 82a. Then, the movable block 82b and the movable block 72 of the LM guide 70 are connected through an L-shaped structural member 83, so that the movable block 72 of the LM guide 70 performs its predetermined motion through the controlling of the motor 81.

The surroundings of the LM guide 70 are covered by an acrylic case 85 so as to easily measure the amount of dust generated only from the LM guide excluding dust generated from the outside thereof. A particle counter 86 is connected to the acrylic case 85 so as to measure the amount of the dust generated inside the acrylic case 85.

The dust generation test of this time was carried out under the conditions shown in the following Table 3. The specific conditions are as follows: stroke: 200mm; velocity at the time of linear motion: 250mm/s; increasing or decreasing velocity at a returning time: 2.548m/s$^2$ (0.26G); and dwell time: 0.08s. Further, the volume of the acrylic case 85 was 1616cm$^2$, and under the condition of clean air supply amount of 1 litter/210s (0.3litter/min), dust having a particle size of more than 0.1 $\mu$m was measured for 50Hr. Herein, with the LM guide using vacuum grease, the result of the measurement carried out for 15Hr was adopted because much dust was generated during the test.

Table 3: Conditions of Dust Generation Test

| Items | Contents |
|---|---|
| Stroke | 200mm |
| Velocity | $\pm$ 250mm/s |
| Increasing or Decreasing Velocity | 2.548m/s$^2$ (0.26G) |
| Dwell Time | 0.08s |
| Volume of Container | 1616cm$^2$ |
| Air Supply Amount | 1 litter/210s (0.3 litter/min) |
| Measured Particle Diameter | More than 0.1 $\mu$m |
| Investigating Time | 50Hr |
| Lubrication | Oil Free |
| Test Machine | Dust Generation Test Machine (Manufactured by THK): Particle Counter KC-18 (GKBKK007) |
| Test Equipment | Clean Room |
| Environment Temperature | 24 °C |
| Environment Moisture | 20%RH |
| Degree of Cleanness | Class 2 (Within Clean Bench) |

The result of the dust generation test carried out under the above conditions will be described hereunder.

The following Table 4 represents a result in the case of the solid lubricant film of the present embodiment and the case of the vacuum grease as to the amount of the generated dust of each particle size ($\mu$m). Herein, the Table 4 includes an upper Table showing the maximum value of the amount of the generated dust and a lower Table showing an average value of the amount of the generated dust.

Table 4: Results of Dust Generation Test

| Test Product | Lubricant | Amount of Generated Dust of Each Particle Size ($\mu$m) (Maximum Value) | | | | |
|---|---|---|---|---|---|---|
| | | 0.1-0.15 | 0.15-0.2 | 0.2-0.3 | 0.3-0.5 | 0.5-more |
| Present Invention | Solid Lubricant Film | 4 | 3 | 3 | 3 | 2 |
| Comparative Example | Vacuum Grease | 39 | 25 | 16 | 11 | 7 |

| Test Product | Lubricant | Amount of Generated Dust of Each Particle Size ($\mu$m) (Average Value) | | | | |
|---|---|---|---|---|---|---|
| | | 0.1-0.15 | 0.15-0.2 | 0.2-0.3 | 0.3-0.5 | 0.5-more |
| Present Invention | Solid Lubricant Film | 0.12 | 0.084 | 0.079 | 0.065 | 0.043 |
| Comparative Example | Vacuum Grease | 19.4 | 8.8 | 5.4 | 2.4 | 1.2 |

From the above Table 4, it will be found that the solid lubricant film according to the present embodiment provides good characteristic features with respect to the anti-dust generation property (dust proof property). Especially, the good results are shown with respect to the amount of generated dust of the small particle (which is likely generated) sizes (i.e., 4/litter (210s) at the maximum value, and 0.12/litter (210s) at the average value), and in comparison with the case of the vacuum grease, the high dust proof property could be shown. Further, Fig. 11 shows a bar graph representing the test results of the lower one of the Table 4, and by visualizing such results, the superiority of the solid lubricant film of the present embodiment will be confirmed.

[Application to Linear Rolling Guide Device]

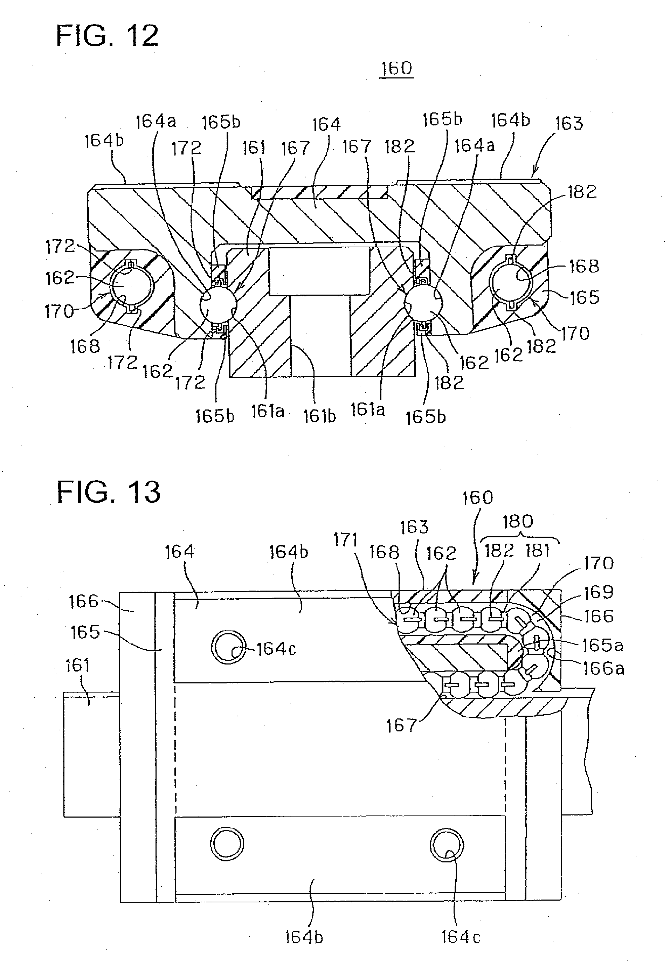

Figs. 12 and 13 show an example of a rolling guide device to which the solid lubricant film of the present embodiment is applied. This rolling guide device 160 is provided with a track rail 161 as a track member and a movable member 163 with a number of balls 162, 162 --- being disposed between the movable member and the track member.
The track rail 161 is a long scale member having substantially a rectangular shape in section, and a pair of right and left rows of loaded rolling grooves 161a, 161a are formed entirely to and along both side surfaces of the track rail 161 so as to be capable of receiving the balls 162, 162. The track rail 161 are also formed with a plurality of bolt mount holes 161b with suitable interval in the longitudinal direction thereof, and the track rail 161 is fixed to a predetermined mount surface, for example, an upper surface of a bed of a machine tool by means of bolts, not shown, screwed with the bolt mount holes 161b, 161b. Although, in the illustrated track rail 161 is a linear one, a curved track rail may be used.
The movable member 163 is provided with a block body 164 made of material having high strength such as steel, a mold product member 165 made of synthetic resin and integrally molded with the block body 164 as an insert member, and side lids 166, 166 fixed to both ends of the mold product member 165 by means of bolts, not shown. As such synthetic resin material, it is desirable to use at least one of polytetrafluoroethylene resin (PTFE) polyimide (PI), polyamide (PA), polyoxyethlene (POM), polyester, phenol resin, epoxy resin, polyetereterketone, (PEEK) or polyetersulfone. Further, the mold product member 165 may be formed separately from the block body 164 and is assembled therewith in the following process. The movable member 163 may be also formed from a block of steel with holes including no resin material.
The block body 164 is formed with a two rows of loaded rolling grooves 164a, 164a, in form of thread, opposing to the loaded rolling grooves 161a, 161a, respectively. Combination of the loaded rolling grooves 164a, 164a with the loaded rolling grooves 161a, 161a constitutes two rows of loaded rolling passages 167, 167 between the track rail 161 and the movable member 163. A plurality (four, in Fig. 13) of female screws 164c, 164c, --- are formed on the upper surface 164b of the block body 164. By utilizing these female screws 164c, the movable block 163 is fixed to the predetermined mount surface such as lower surface of a saddle or table of a machine tool.
Two return passages 168, 168 are formed to the mold product member 165 so as to extend in parallel with the respective loaded rolling passages 167, 167. Ball guide portions165a, 165a, --- projecting in form of arch are formed (one on only one end side is shown in Fig. 13) between the loaded rolling grooves 164a and the return passages 168 at both end surfaces of the mold product member 165. The side lid 166 is formed with a ball guide groove 166a recessed in an arch shape corresponding to the ball guide portion 165a.
By fixing the side lid 166 to the mold product member 165, the ball guide portion 165a and the ball guide groove 166a are combined to thereby form a U-shaped direction changing passage 169 connecting the loaded rolling passage 167 and the return passage 168. A non-loaded ball rolling passage 170 is formed by the combination of the return passage 168 and the direction changing member 169, and on the other hand, an endless circulation passage 171 is also formed by the combination of the non-loaded rolling passage 170 and the loaded rolling passage 167. The sectional shape and dimension of the endless circulation passage 171 are set so as to describe a circular section having the same diameter as that of the ball 162 at the loaded rolling passage 167 and to describe a circular section having a diameter slightly larger than that of the ball at the non-loaded rolling passage 170.
As shown in Fig. 13, the mold product member 165 is formed with a pair of ball retainer portions 165b, 165b so as to snap the loaded rolling groove 164a to prevent the ball 162 from coming off from the loaded rolling passage 167 at the time when the movable member 163 is withdrawn from the track rail 161. Further, the guide groove 172 of the loaded rolling passage 167 is formed to these ball retainer portions 165b, 165b. In addition, in the return passage 168, a pair of guide grooves 172 are formed with respect to the mold product member 165, and in the direction changing passage 169, a guide groove 172 is formed between the ball guide portion 165a and the ball guide groove 166a.
In the present embodiment, the solid lubricant film is formed to the balls 162, 162, --- as rolling members by the CUMS apparatus mentioned before. This solid lubricant film have film structures as shown in Fig. 4 or Fig. 5, and the most outer surface of the film has a low friction coefficient, withstands the inner repeated stress and has high adhesion performance. Such solid lubricant film has never been broken from the inside or boundary portion thereof, and is worn from the film surface at the slowest wearing speed, thus realizing reliable and ideal conditions. Accordingly, by applying such solid lubricant film to the rolling guide device shown in Figs. 12 and 13, the rolling guide device becomes usable under a specific environment or condition such as undesirable lubricating condition, high temperature vacuum condition, or condition in which any lubricant such as grease is not usable.

Further, the object to which the solid lubricant film is formed by the CUMS apparatus is not limited to the balls 162, 162, ---, and the solid lubricant film may be formed to at least one surface of a member, such as loaded rolling passage 167 or non-loaded rolling passage 170, to which a rolling pressure or sliding pressure is applied. Further, the reason why, in the described embodiment, the solid lubricant film is formed only to the balls 162 as rolling members resides in that the solid lubricant film can be easily formed to the balls by the CUMS apparatus.

In addition, it is possible to arrange a spacer member made of a material softer than the rolling member such as ball 162 and the solid lubricant film between the balls 162, 162, --- of the rolling guide device mentioned above. As such spacer member, there is provided a spacer ball or retainer having a diameter less than that of the ball 162 as the rolling member. Such spacer member prevents the balls from interfering with each other or colliding with each other and prevents the balls from coming off. In addition, the spacer member contributes to the fine linear motion of the balls 162, 162, --- and the improvement of the abrasion resisting property of the rolling guide device in addition to the self lubricating property of the spacer and compound lubricating property thereof with the solid lubricant film, thus being effective and advantageous.

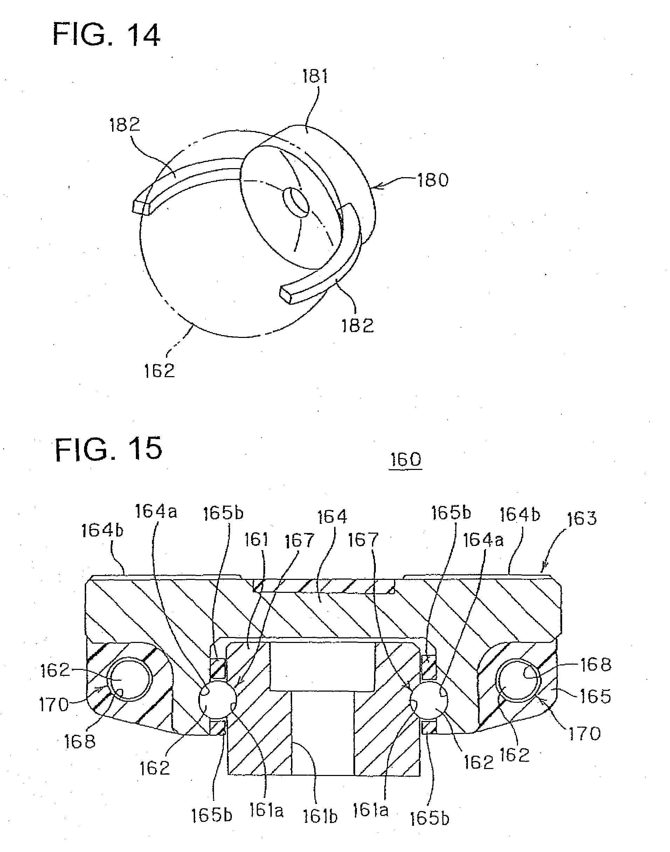

The specific shapes of the spacers are shown in Figs. 12 and 13, and it may be possible, as shown in detail in Fig. 14, to adopt a spacer member 180 composed of a spacer piece 181 and arm pieces 182, 182.

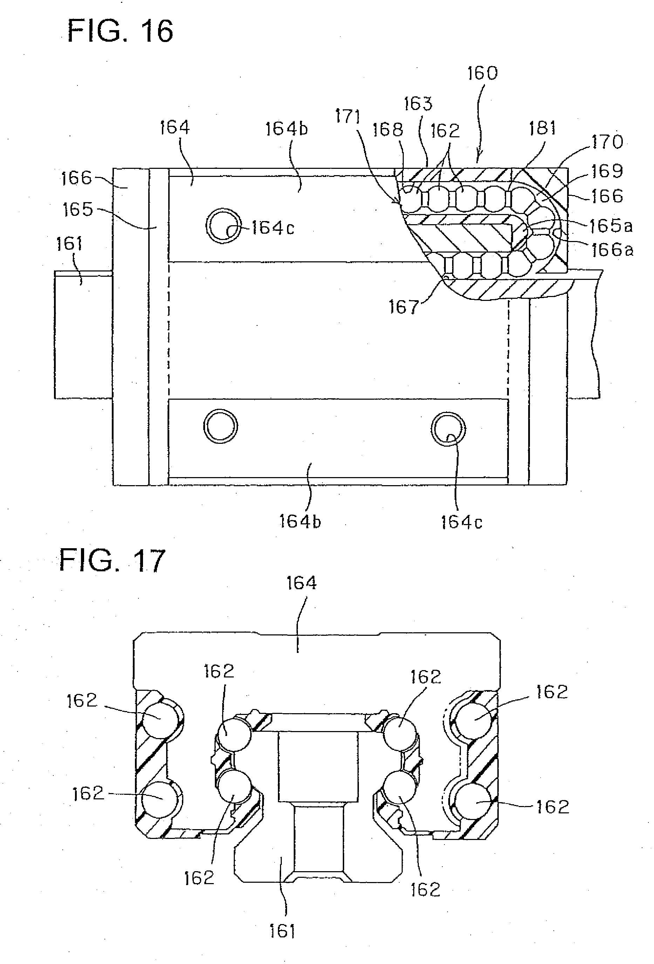

Further, in the rolling guide device shown in Figs. 12, 13 and 14, although the spacer member 180 is provided with the arm pieces 182, 182, it is of course possible to constitute the spacer only with the spacer piece 181 as shown in Figs. 15 and 16. Further, in Figs. 12, 13 and 14, although the rolling guide device having two rows of endless circulation passages 171, a rolling guide device having four rows of endless circulation passages, as shown in Fig. 17, may be provided as one to which the solid lubricant film of the present invention is applicable.

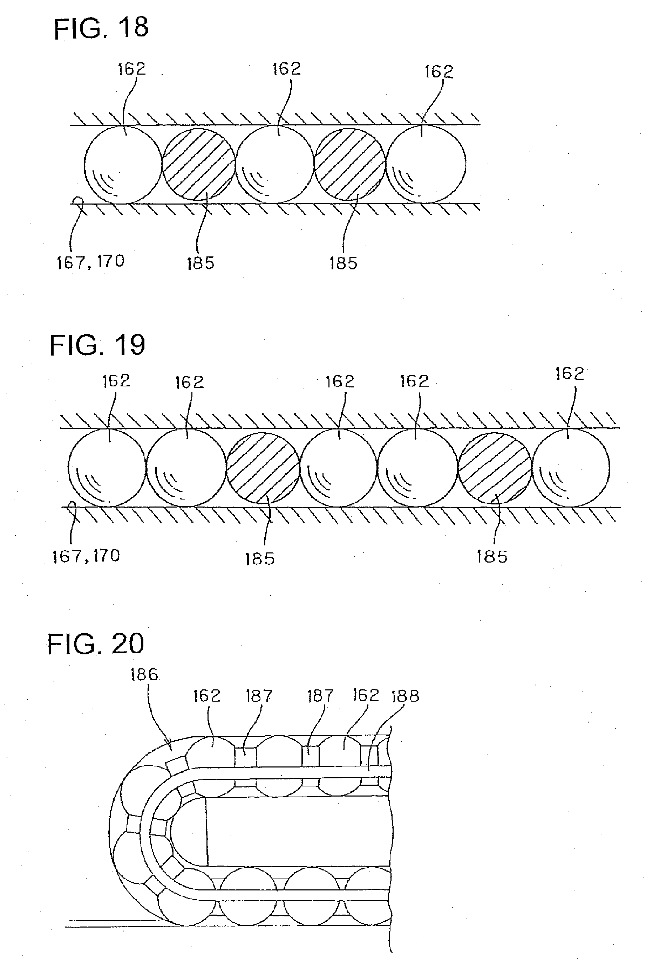

Furthermore, the spacer member may be formed as a spacer ball 185 such as shown in Fig. 18 having a diameter less than that of the ball 162, and may be also formed as a retainer 186 such as shown in Fig. 20.

Incidentally, one spacer ball 185 may be incorporated with respect to one ball 162 as shown in Fig. 18, but as shown in Fig. 19, one spacer ball 185 may be incorporated with respect to every two balls 162, 162. The number of the spacer ball 185 to be incorporated will be determined such that at least one or more spacer ball 185 is incorporated in the balls, and preferably, the ball or balls 162 is necessarily sandwiched between the spacer balls 185, 185. Accordingly, it is desired that the following equation is established, wherein symbol X represents the number of ball 162 and symbol Y is the number of the spacer ball 185.

$$ 1 \leqq Y \leqq (X + 1) $$

On the other hand, the retainer 186 shown in Fig. 20 is provided with a plurality of spacers 187, 187, --- disposed between the balls 162, 162, --- and belt-shaped members 188 connecting in series both side ends of the spacers 187, 187, ---. The spacer 187 has a cylindrical shape having a diameter smaller than that of the ball 162. Both end portions in the axial direction of each of the spacers 187 are formed so as to provide curved concave shape facing the balls 162 and having a curvature of radius equal to the radius of the ball 162. When the spacers 187, 187, --- are arranged between the balls 162, 162, ---, the axes of the spacers 187 are positioned on a line connecting the center portions of the respective balls 162, 162, ---. The spacer 187 has a thin thickness in the axial direction so that a distance between the adjacent balls 162, 162 become a necessarily minimum distance.

The belt-shaped member 188 has a constant thickness and is connected to each of both the side surfaces of the spacers 187 (only one side is shown in Fig. 20). This belt-shaped member 188 has a flexibility so as to be flexibly bent in the direction changing passage 169.

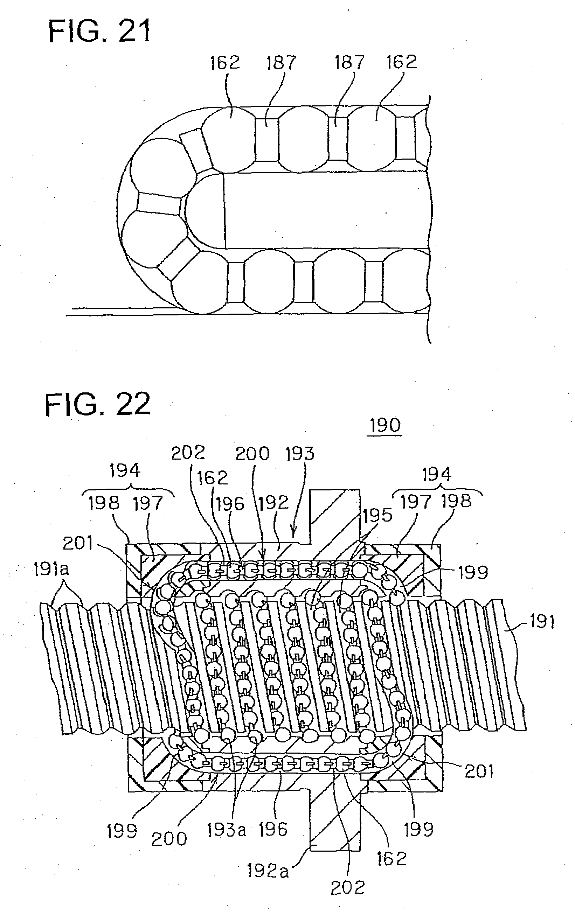

As shown in Fig. 21, however, the belt-shaped member 188 may be eliminated and the spacer member may be composed of only the spacer 187. As mentioned, even if the spacer member is provided with no belt-shaped member 188, substantially the same advantageous effects as those mentioned with reference to the retainer 186 shown in Fig. 20 will be attained.

It is desired for the spacer member to be formed of a resin including at least one of polytetrafluoroethylene (PTFE), polyimide (PI), polyamide (PA), polyoxymethylene (POM), polyester, phenol resin, epoxy resin, polyetereterketone (PEEK) or polyetersulfone (PES). The spacer member is formed from a single or compound resin selected from the above resins by an injection molding process.

In the resins mentioned above, the PTFE has a self lubricating property and is generally used as a solid lubricant, so that the PTFE is preferably utilized for the rolling guide device of the present embodiment. This is because that the PTFE has an extremely low friction coefficient in its structure and achieves the lubricity by forming a transfer film on a friction surface of the object. In addition, in order to improve the abrasion resistance, it may be possible to use, as the spacer or retainer, a composite material made of the PTFE and carbon fiber, non-amorphous carbon, glass, ceramics, and compound of other resin.

Furthermore, the formation of the transfer film of the PTFE having further thin thickness on the solid lubricant film of the present embodiment makes it possible to reduce a surface energy of the film of $MoS_2$ or $WS_2$ induced with metallic atom and reduce the friction coefficient with respect to steel and ceramics. Accordingly, the specific abrasion ratio and dust generation ratio will be significantly reduced.

[Applied Example to Ball Screw Device]

The rolling guide device using the solid lubricant film of the described embodiment may be constituted as a ball screw device shown in Fig. 22. Fig. 22 is a view showing one example of a ball screw device using the solid lubricant film according to the present embodiment.

As shown in Fig. 22, a ball screw device 190 is provided with a screw shaft 191 as a track member and a nut 192 as a movable member installed to be movable with respect to the track member through a number of balls 162, 162, --- as rolling members disposed therebetween. Two rows of loaded rolling grooves 191a, 191a are formed to the outer periphery of the screw shaft 191 so as to extend spirally around the screw shaft 191.

The nut 192 is provided with a nut body 193 made of a material having a high strength such as steel and lid members 194, 194 mounted on both ends of the nut body 193. A flange 192 is formed to the outer periphery of the nut body 193 so as to attach the nut 192 to its object member. Two loaded rolling grooves 193a, 193a are formed to the inner periphery of the nut body 193 so as to face the loaded rolling grooves 191a, 191a, respectively, and extend spirally along the inner periphery of the nut body 193. The combination of the loaded rolling grooves 191a, 191a and 193a, 193a constitutes two spiral loaded rolling passages 195, 195, respectively.

Inside the nut body 193, two return passages 196, 196 are formed so as to axially penetrate the nut body 193. Each of the lids 194 has a return piece 197 and a cover 198 covering the outside thereof. Combination of the return passages 196, 196 and the direction changing passages 199, 199 constitutes non-loaded rolling passages 200, 200, respectively, for the balls 162, 162, and combination of the non-loaded rolling passages 200, 200 and the loaded rolling passages 195, 195 constitutes two rows of endless circulation passages 201, 201, respectively.

In the present embodiment, the solid lubricant film is formed to the balls 162, 162 as rolling members by the CUMS apparatus mentioned before. This solid lubricant film has a film structure such as shown in Fig. 4 or Fig. 5, in which low friction coefficient is provided at the most outer surface of the film, it can therefore withstand the inner repeated stress and it has high adhesion performance. Such solid lubricant film provides an ideal condition such that it have not been broken from its inside or boundary portion and has worn from the film surface at the minimum wearing speed, so that by applying the solid lubricant film to the ball screw device 190 shown in Fig. 22, it becomes possible to use the rolling guide device under a specific environment such as an undesirable lubricating environment including poor lubrication, high temperature vacuum condition, or a condition in which a lubricant such as grease is not used.

It is further to be noted that the object to which the solid lubricant film is formed by the CUMS apparatus is not limited to the balls 162, 162, --- and it is applicable to at least one surface of a member, such as loaded rolling passage 195 or non-loaded rolling passage 200, to which rolling pressure or sliding pressure is applied. In the described embodiment, the reason why the solid lubricant film is only formed to the balls 162 as the rolling members resides in that the solid lubricant film can be easily formed to the balls by the CUMS apparatus.

Furthermore, it may be possible to arrange a spacer member 202 having a hardness softer than that of the solid lubricant film applied to the rolling members such as balls 162 between the balls 162, 162 of the ball screw device 190. With the spacer 202, as like as the case of the linear rolling guide device 160, the spacer ball or retainer having a diameter smaller than that of the ball 162 may be adopted. Such spacer member 202 can attain the functions of preventing the balls from interfering with each other and from coming off, realizing the aligning motion of the balls 162, and improving the abrasion resistance of the rolling guide device in combination of the self lubricity of the spacer member 202 and the compound lubricity of the solid lubricant film. Further, since the shape and substance of the spacer member 202 are the same as those of the linear rolling guide device 160 mentioned above, so that the detailed explanation thereof is omitted herein.

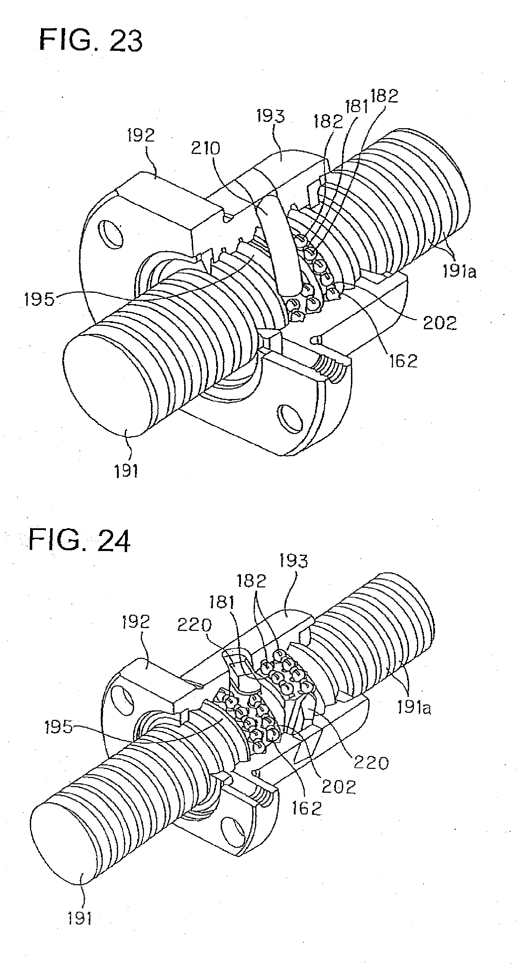

The ball screw device 190 according to the described embodiment is not limited to such the structure as shown in Fig. 22 in which the return piece 197 as an independent part is mounted to each end of the nut 193 for constituting the direction changing passage 199. For example, a structure such as shown in Fig. 23, in which return pipes 210, 210 are mounted to the nut body 193 and an endless circulation passage is formed by the non-loaded rolling passage formed inside the return pipe 210 and the loaded rolling passage 195, may be adopted, or a structure, such as shown in Fig. 24, in which a plurality (two in the illustration) of deflectors 220, 220, --- are mounted to the nut body 193 and an endless circulation passage is formed by the non-loaded rolling passage formed to the deflector and the loaded rolling passage 195, may be also adopted. The application of the solid lubricant film of the present embodiment to such the ball screw devices in which the balls 162, 162, --- are circulated in the different ball circulation passages (such as return pipes of Fig. 23 and deflectors in Fig. 24) can attain substantially the same advantageous effects and functions as those mentioned above with reference to the rolling guide device 160 and the ball screw device 190.

It is further noted that the present invention is not limited to the described embodiments and many other changes and modifications may be made without departing from the scopes of the appended claims. For example, there was described the case in which the solid lubricant film according to the present embodiment is formed by inducing the metallic atoms with respect to layered crystal compound formed by $MoS_2$, $WS_2$ or graphite, but diamond-carbon or diamond-like-carbon (DLC) may be applied as the layered crystal compound.

**Claims**

1. A rolling guide device comprising:

   a track member; and
   a movable member mounted to the track member to be movable through a number of rolling members,
   the number of rolling members being disposed in an endless circulation passage composed of a loaded rolling passage formed between the track member and the movable member and in a non-loaded rolling passage formed by connecting one and other ends of the loaded rolling passage,

   wherein a solid lubricant film formed by inducing a metallic atom into a laminated crystal compound with respect to at least one surface of the rolling members, the loaded rolling passage and the non-loaded rolling passage.

2. The rolling guide device according to claim 1, wherein the solid lubricant film is formed by a closed magnetic field unbalanced magnetron spattering method.

3. The rolling guide device according to claim 1 or 2, wherein the laminated crystal compound includes at least one of $MoS_2$, $WS_2$ or graphite, and the metallic atom includes at least one of titanium, tungsten, aluminum, chromium, zirconium, silica or boron.

4. The rolling guide device according to any one of claims 1 to 3, wherein the solid lubricant film has a film thickness of 0.5 to 3 $\mu$m.

5. The rolling guide device according to any one of claims 1 to 4, wherein the metallic atom has a content of less than 20% with respect to the solid lubricant film.

6. The rolling guide device according to any one of claims 1 to 5, wherein the solid lubricant film has a critical adhesion performance in a scratch test using Rockwell diamond indenter of not less than 40N.

7. The rolling guide device according to any one of claims 1 to 6, wherein the solid lubricant film has a Vickers hardness of not less than 500 and has a friction coefficient of not more than 0.07 with respect to a steel material having a hardness of not less than HRC55 in a vacuum condition of not more than 1 x $10^{-3}$ Torr.

8. The rolling guide device according to any one of claims 1 to 7, wherein a spacer member is arranged between the rolling members having a hardness lower than that of the solid lubricant film, the spacer member being a spacer ball or a retainer having a diameter less than that of the rolling member.

# FIG. 1

# FIG. 2

## FIG. 3

Mag.c (MoS₂)

Mag.b (Ti)

Mag.d (MoS₂)

Mag.a (MoS₂)

## FIG. 4

# FIG. 5

# FIG. 6

## FIG. 7

## FIG. 8A

# FIG. 8B

# FIG. 9

| No. | 200km | 400km | 600km | 800km | | | |
|---|---|---|---|---|---|---|---|
| 1 | ///////////////////////// 587 | | | | | | |
| 2 | ////////////////////////// 599 | | | | | | |
| 3 | /////////////////////////// 632 | | | | | | |
| 4 | //////////////////////////// 660 | | | | | | |
| 5 | \\\\\\ 173 | | | | | | |
| 6 | \\\\\\\ 198 | | | | | | |
| 7 | \\\\\\ 180 | | | | | | |
| 8 | \\\\\\ 190 | | | | | | |
| DLC | ⊠ 26 | | | | | | |

## FIG. 10

## FIG. 11

# FIG. 12

160

164b 164a 165b 161 167 164 167 182 165b 164b 163
172 172 164a 182

172
162
170
168
172 162 172
165b 161a 161b 161a 165b

168
165
170
162 162 182

# FIG. 13

160
163 180
164 164b 171 168 162 182 181
170
166 169
165 166
161 164c 165a
166a
167
164b 164c

## FIG. 14

## FIG. 15

160

## FIG. 16

## FIG. 17

FIG. 18

162   162   162

167, 170   185   185

FIG. 19

162   162   162   162   162

167, 170   185   185

FIG. 20

186   162   187   187   162   188

## FIG. 21

## FIG. 22

## FIG. 23

## FIG. 24

<div style="text-align:center">**INTERNATIONAL SEARCH REPORT**</div>

| | International application No. |
|---|---|
| | PCT/JP2005/018200 |

**A. CLASSIFICATION OF SUBJECT MATTER**
*F16C29/06*(2006.01), *F16C33/37*(2006.01), *F16C33/66*(2006.01), *F16H25/22*(2006.01), *F16H25/24*(2006.01)

According to International Patent Classification (IPC) or to both national classification and IPC

**B. FIELDS SEARCHED**

Minimum documentation searched (classification system followed by classification symbols)
F16C29/04-29/06, F16C33/30-33/66

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 10-141372 A (Toshiba Corp.), 26 May, 1998 (26.05.98), Par. Nos. [0013] to [0016]; Figs. 1, 2 & US 5980111 A | 1-8 |
| Y | JP 11-509580 A (TEER COATINGS LTD.), 24 August, 1999 (24.08.99), Claims; page 15, lines 10 to 23; page 20, line 21 to page 21, line 5; page 21, line 23 to page 22, line 5 & GB 2303380 A & WO 97/004142 A1 | 1-7 |
| Y | BERNARD C. STUPP, SYNERGISTIC EFFECTS OF METALS CO-SPUTTERED WITH MoS2, Thin Solid Films, Vol.84, 1981, pages 257 to 266 | 1,3 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 06 January, 2006 (06.01.06) | 17 January, 2006 (17.01.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2005/018200

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 10-89364 A (Yaskawa Electric Corp.), 07 April, 1998 (07.04.98), Claims; Par. Nos. [0005] to [0007]; Figs. 1, 2 (Family: none) | 8 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9144764 A
- JP 2000136828 A
- JP 2000205277 A
- JP 2000205279 A
- JP 2000205280 A
- GB 2303380 A